# EUROPEAN PATENT SPECIFICATION

(11) **EP 1 030 222 B1**
(45) Date of publication and mention of the grant of the patent: **04.01.2006**
(21) Application number: 00301041.0
(22) Date of filing: 09.02.2000
(51) Int. Cl.: G03F 7/20, H01J 37/317

(54) **Lithographic projection apparatus**
Lithographischer Projektionsapparat
Appareil de projection lithographique

(30) Priority: 18.02.1999 EP 99200462
(43) Date of publication of application: 23.08.2000
(73) Proprietor: ASML Netherlands B.V., 5504 DR Veldhoven (NL)
(72) Inventor: Bleeker, Arno Jan, New Jersey, NJ 07928 (US)
(74) Representative: Leeming, John Gerard

(56) References cited:
- EP-A- 0 409 572
- EP-A- 0 823 662
- EP-A- 0 841 681
- US-A- 4 616 130
- US-A- 5 004 348
- PATENT ABSTRACTS OF JAPAN vol. 1999, no. 02, 26 February 1999 (1999-02-26) -& JP 10 303125 A (TOSHIBA CORP), 13 November 1998 (1998-11-13) -& US 5 989 759 A (ANDO ATSUSHI ET AL) 23 November 1999 (1999-11-23)

## Description

The invention relates to a lithographic projection apparatus comprising:
- a radiation system for supplying a projection beam of radiation of a first type;
- a mask table for holding a mask;
- a substrate table for holding a substrate;
- a projection system for imaging a portion of the mask, irradiated by the projection beam, onto a target portion of the substrate.

In particular, the invention relates to such a device in which the radiation of the first type comprises particulate radiation (e.g. electrons or ions).

An apparatus of this type can be used, for example, in the manufacture of integrated circuits (ICs). In such a case, the mask (reticle) may contain a circuit pattern corresponding to an individual layer of the IC, and this pattern can then be imaged onto a target area (die) on a substrate (silicon wafer) which has been coated with a layer of photosensitive material (resist). In general, a single wafer will contain a whole network of adjacent dies that are successively irradiated through the reticle, one at a time. In one type of lithographic projection apparatus, each die is irradiated by exposing the entire reticle pattern onto the die in one go; such an apparatus is commonly referred to as a waferstepper. In an alternative apparatus ― which is commonly referred to as a step-and-scan apparatus ― each die is irradiated by progressively scanning the reticle pattern under the projection beam in a given reference direction (the "scanning" direction) while synchronously scanning the wafer table parallel or anti-parallel to this direction; since, in general, the projection system will have a magnification factor M (usually, M < 1), the speed *v* at which the wafer table is scanned will be a factor M times that at which the reticle table is scanned. More information with regard to lithographic devices as here described can be gleaned from International Patent Application WO 97/33205, for example.

Up to very recently, apparatus of this type contained a single mask table and a single substrate table. However, machines are now becoming available in which there are at least two independently movable substrate tables; see, for example, the multi-stage apparatus described in International Patent Applications WO 98/28665 and WO98/40791. The basic operating principle behind such multi-stage apparatus is that, while a first substrate table is underneath the projection system so as to allow exposure of a first substrate located on that table, a second substrate table can run to a loading position, discharge an exposed substrate, pick up a new substrate, perform some initial alignment and/or leveling measurements on the new substrate, and then stand by to transfer this new substrate to the exposure position underneath the projection system as soon as exposure of the first substrate is completed, whence the cycle repeats itself; in this manner, it is possible to achieve a substantially increased machine throughput, which in turn improves the cost of ownership of the machine.

When radiation of the first type impinges on the substrate, energy from the radiation will generally be absorbed by the substrate, causing localized heating of the target area (die) which is being irradiated at that moment. In contrast, the substrate area outside the die, which is not being irradiated at that moment, will not undergo localized heating in this manner. Substrate heating is thus highly differential in nature, and can consequently cause significant differential stress in the substrate, with attendant mechanical deformation (expansion/contraction). This deformation can have a highly detrimental effect *inter alia* on the so-called overlay performance of the lithographic apparatus, which term refers to the accuracy with which a second patterned layer (new layer) can be juxtaposed upon a first patterned layer (old layer) already present on the substrate.

Although this problem is, in principle, present to some extent in all currently produced lithographic projection apparatus (in which the radiation of the first type is, for example, ultra-violet (UV) radiation with a wavelength of 365 or 248 nm), its magnitude is usually not so great as to cause substantial under-performance of the apparatus. However, a very different situation applies in the case of next-generation lithography systems, in which the radiation of the first type comprises, for example, electrons, ions, X-rays or EUV radiation (*i*.*e*. UV with a wavelength in the range 10-25 nm, *e*.*g*. 13.6 nm); in such apparatus, localized heating of the substrate can be quite intense.

It is an object of the invention to alleviate this problem. In particular, it is an object of the invention to provide a lithographic projection apparatus in which the effects of differential heating of a substrate during exposure are reduced.

EP409572A discloses an electron beam lithographic projection apparatus according to the pre-characterizing portion of claim 1.

EP-A-0 823 662 discloses an apparatus for UV lithography for alleviating rotationally asymmetrical thermal distortions in the projection lens.

According to the present invention there is provided a lithographic projection apparatus according to claim 1.

Another aspect of the invention provides a device manufacturing method according to claim 16.
By suitable embodiment of the control means, the sum of the fluxes of the radiations of the first and second type at substrate level will cause an elevation of the substrate temperature which is substantially constant across at least a given area of the substrate.

In essence, the invention ensures that parts of the substrate which are not illuminated by the radiation of the first type are illuminated (and consequently heated) by radiation of the second type, and *vice versa;* however, appropriate choice of the photosensitive material on the substrate, and of the type (e.g. wavelength) of the radiation of the second type, will ensure that the photosensitive material will only be exposed by the first-type radiation, and not by the second-type radiation. Proper adjustment of the second-type radiation dose at substrate level ensures that the substrate surface is heated to a substantially uniform temperature over at least that area which is to be covered with whole dies, thereby combating differential heating effects. Use of the word "substantially" in this context does not require exact uniformity of the substrate's surfacial temperature (although this is, of course, generally preferred).

The current invention can be envisaged at different levels, thus determining the size of the "given area" referred to in the penultimate paragraph above. For example, at a basic level, when one die (target area) on the substrate is being exposed to first-type radiation, the (whole) substrate area outside that die can be concurrently exposed to second-type radiation; this will be referred to hereunder as a "coarse-level correction". On a deeper level, the invention can be applied within a given die: the shadowed (masked) areas within that die are then irradiated with second-type radiation while the rest of the area within the die is exposed to first-type radiation; this will be referred to hereunder as a "fine-level correction". It is also possible to combine a coarse-level and fine-level correction.

In a first embodiment of the apparatus according to the invention, the radiation of the first type comprises charged particles, for example selected from the group formed by electrons and ions. Lithographic systems employing such post-optical radiation are presently undergoing development and preliminary testing by several companies, in reply to the semiconductor industry's continuing drive toward smaller feature sizes, and the consequent demand for greater lithographic image resolution. Preliminary investigations have shown that the use of such radiation types can lead to very substantial substrate heating, with the attendant risk of producing significant differential stresses in the substrate; consequently, the present invention represents a particularly important contribution to these technologies. More information with regard to post-optical lithographic apparatus can be obtained, for example, from:
- United States Patents US 5,079,112 and US 5,260,151, in the case of SCALPEL lithography employing an electron source;
- United States Patent US 5,532,496, relating to another electron-beam lithographic apparatus;
- European Patent Application EP 0 779 528 and United States Patent US 5,153,898, in the case of EUV lithography.

In a particular embodiment of the apparatus according to the invention, the radiation of the second type is selected from the group formed by microwaves, infrared radiation, visible light, and ultra-violet radiation. As already stated above, the resist employed on the substrate must be substantially insensitive to the radiation of the second type. For example, in the case of electron-beam lithography and ion-beam lithography, it is possible to use one of the resists currently available for use with DUV radiation (wavelength: 248 nm); in that case, the employed second-type radiation must be one to which such DUV resists are insensitive, e.g. infra-red radiation, or visible light with a wavelength longer than yellow. On the other hand, in the case of an EUV resist, a near-UV wavelength may prove suitable for use as second-type radiation. The skilled artisan will appreciate this point, and will be able to deduce a suitable combination of resist and second-type radiation on the basis of a given first-type radiation. Moreover, it will be obvious to the skilled artisan that:
- the use of a radiation type such as microwave radiation or infrared radiation as a second-type radiation will generally only be appropriate in performing a coarse-level correction (see above). This is because these radiation types do not generally lend themselves to fine patterning/focusing at the resolution of the features typically present in a die;
- the successful use of the chosen second-type radiation in performing a fine-level correction (see above) will depend on the resolution of the features being imaged using the first-type radiation; if this resolution is too fine, then the (less energetic) second-type radiation will be difficult to pattern/focus at the required resolution. In this respect, performing a coarse-level correction is much easier, since, in that case, the second-type radiation need only be patterned/focused to a resolution of the order of millimeters (the width of a die) or centimeters (the width of a wafer) rather than tens of nanometers (the width of the individual IC features within a die).

In a particular embodiment of the inventive apparatus, the control means comprise a stencil plate. As already stated above, the second-type radiation should impinge on parts of the substrate that are not illuminated by the first-type radiation, and *vice versa.* This can be realized in a relatively simple manner by locating a stencil plate between the secondary radiation source and the substrate. In the case of a coarse-level correction, such a stencil plate will comprise an obscuration which shields a shadow-area the size of a die (or, in the case of a step-and-scan device, the size of the scanning slit-image on the substrate), while allowing radiation access to the region around the shadow-area; in use, the plate will be positioned at any given moment during the wafer exposure such that the shadow-area coincides with a subject die upon which imaging is occurring (with first type radiation), whereby second-type radiation is allowed to impinge on (all) areas of the wafer except the said subject die (in the case of a step-and-scan device, the second-type radiation will be allowed to impinge on the substrate area outside the (moving) slit area). In the case of a fine-level correction, on the other hand, at least part of the stencil plate should contain a pattern which is substantially a negative of the pattern to be imaged onto each die (using first-type radiation); the term "negative" here indicates that the stencil pattern is an inverse or complementary image of the pattern to be imaged on the die.

An alternative embodiment of the apparatus according to the invention is characterized in that the control means comprise:
- programmable memory means, for storing information regarding a pattern to be projected from the mask;
- scanning means, for scanning a radiation beam from the secondary light source over the surface of the substrate;
- attenuator means, for adjusting the intensity of the secondary light source during the said scanning motion, on the basis of the information stored in the memory means, thus causing patterned irradiation of the substrate with radiation of the second type.
In this embodiment, a beam of second-type radiation is scanned over an appropriate area of the substrate and is concurrently intensity-modulated so as to produce a patterned dose. For example, during exposure of a given die with first-type radiation, the intensity of the scanning second-type beam is kept relatively high in the shadow-areas within the die, and relatively low in the other areas within the die. Outside the die, the intensity of the second-type radiation is kept relatively high; this can be achieved not only using the said scanning technique, but also using a stencil plate, for example.

In the apparatus discussed in the previous paragraph, the memory means can be provided in one go with a "map" of the pattern to be projected from the mask; this can be done, for example, prior to an exposure session (batch), by loading a map-file into the memory means from a map library. Alternatively, the memory means can be programmed "on the fly", using a technique whereby, instead of providing a file with prior information regarding the mask pattern, such information is instead "measured" and stored in memory. In this latter case, an embodiment of the apparatus according to the invention is characterized in that the control means comprise:
- measurement means, for determining the patterned intensity distribution of radiation of the first type at a reference level between the radiation system and the substrate table;
- patterning means, for patterning the output of the secondary source so as to produce a second-type patterned intensity distribution at substrate level which is substantially a negative of the first-type patterned intensity distribution determined by the measurement means.
Examples of such embodiments are given in the next paragraph.

A particular embodiment of the inventive apparatus as described in the previous paragraph is characterized in that:
- the radiation of the first type comprises charged particles;
- the measurement means determine the patterned intensity distribution of the charged particles on the basis of a current measurement at the reference level.
In an alternative version:
- the measurement means determine the patterned intensity distribution of the charged particles on the basis of a secondary electron signal measurement at the reference level.
The charged particles referred to here may be electrons or ions, for example (or, in principle, even other particles, such as protons or muons). The said reference level may, for example, be one of the following:
(a) mask level;
(b) the level of an angle-limiting aperture located in the radiation path between the mask table and the substrate table;
(c) substrate level.
More information on this point is given in the Embodiments below.

The application of the current invention will alleviate the problem of differential heating of a substrate during use of a lithographic apparatus. However, the substrate will still tend to get hot as a whole, and this can also be undesired. Fortunately, it has transpired that such "global" heating of the substrate is alleviated by substantial heat removal through the substrate table on which the substrate is located.

In a manufacturing process using a lithographic projection apparatus according to the invention, a pattern in a mask is imaged onto a substrate which is at least partially covered by a layer of energy-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, *etc.,* all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, *etc.* Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

Although specific reference has been made hereabove to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, *etc*. The skilled artisan will appreciate that, in the context of such alternative applications, any use of the terms "reticle", "wafer" or "die" in this text should be considered as being replaced by the more general terms "mask", "substrate" and "target area", respectively. It will also be appreciated that the apparatus according to the invention may, if desired, contain more than one substrate table and/or more than one mask table (so-called twin-stage or multi-stage machines).

The invention and its attendant advantages will be further elucidated with the aid of exemplary Embodiments and the accompanying schematic drawings, whereby:
Figure 1 schematically depicts a lithographic projection apparatus in which the present invention can be applied;
Figure 2 renders a cross-sectional view of part of the subject of Figure 1, and depicts thereby the principle of operation of an apparatus according to the invention.

In the Figures, corresponding reference symbols denote corresponding parts.

### Embodiment 1

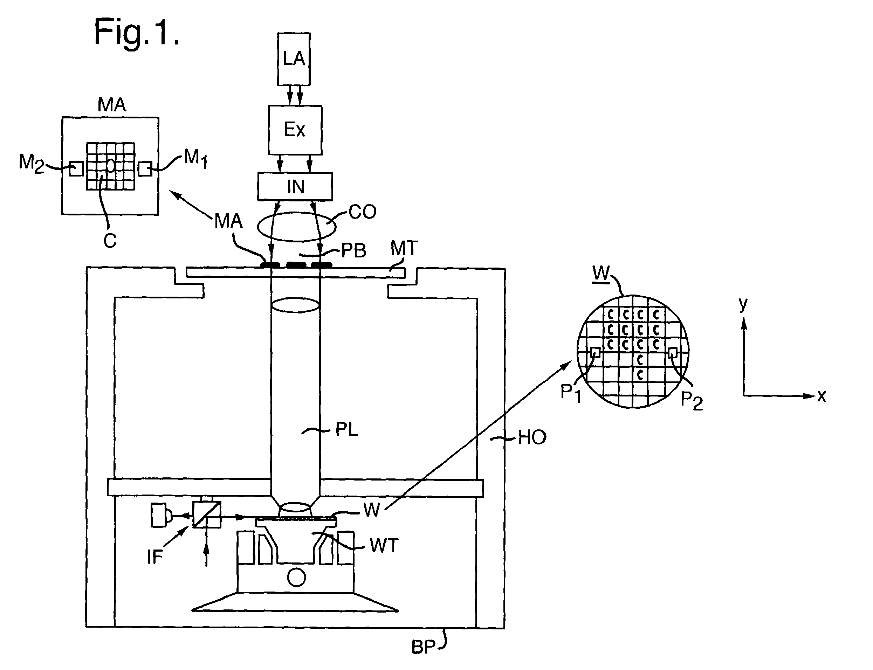

Figure 1 schematically depicts a lithographic projection apparatus in which the current invention can be applied. The apparatus comprises:
- a radiation system LA, Ex, IN, CO for supplying a projection beam PB of radiation comprising charged particles (*e.g.*, electrons or ions);
- a mask table MT provided with a mask holder for holding a mask MA (*e*.*g*. a reticle);
- a substrate table WT provided with a substrate holder for holding a substrate W (*e*.*g*. a resist-coated silicon wafer);
- a projection system PL (*e.g*. a field lens) for imaging an irradiated portion of the mask MA onto a target portion C (die) of the substrate W.
As here depicted, the projection system PL and mask MA are transmissive (which is the actual situation in the case of SCALPEL, for example).

The radiation system comprises a source LA (*e.g*, an electron gun or ion source) that produces a beam of radiation comprising charged particles. This beam is passed along various optical components, ― *e.g*. beam shaping optics Ex, an integrator IN and a condensor CO ― so that the resultant beam PB has a desired shape and intensity distribution in its cross-section.

The beam PB subsequently intercepts the mask MA which is held in a mask holder on a mask table MT. Having passed through (or been reflected from) the mask MA, the beam PB passes through the projection system PL, which focuses the beam PB onto a target area C of the substrate W. With the aid of the interferometric displacement and measuring means IF, the substrate table WT can be moved accurately, *e*.*g*. so as to position different target areas C in the path of the beam PB. In general, movement of the tables MT, WT will be realized with the aid of a long stroke module (course positioning) and a short stroke module (fine positioning), which are not explicitly depicted in Figure 1. In the case of a waferstepper - as opposed to a step-and-scan device - the mask table MT may be provided with only a short-stroke module, for fine positioning.

The depicted apparatus can be used in two different modes:
- In step mode, the mask table MT is fixed, and an entire mask image is projected in one go (*i.e.* a single "flash") onto a target area C. The substrate table WT is then shifted in the X and/or Y directions so that a different target area C can be irradiated by the (stationary) beam PB;
- In scan mode, essentially the same scenario applies, except that a given target area C is not exposed in a single "flash". Instead, the mask table MT is movable in a given direction (the so-called "scan direction", e.g. the Y direction) with a speed v, so that the projection beam PB is caused to scan over a mask image; concurrently, the substrate table WT is simultaneously moved in the same or opposite direction at a speed *V* = *Mv*, in which *M* is the magnification of the projection system PL (typically, *M*= 1/4 or 1/5). In this manner, a relatively large target area C can be exposed, without having to compromise on resolution.

### Embodiment 2

In the apparatus of Figure 1, the plan view of the wafer W at the right of the figure shows the various die areas C into which the wafer W can be subdivided. During use of the lithographic projection apparatus, these die areas C will be imaged onto one at a time. In the case of a waferstepper, for example, this means that, at a given time during the exposure procedure, first-type radiation will only impinge on one particular die area C ("the subject die"), leaving the other die areas C "dark" with respect to the first-type radiation. As a result, the subject die C will become substantially heated through absorption of first-type radiation, whereas the surrounding dies C will remain at a lower temperature. This sizeable temperature difference can cause substantial stress in the wafer, resulting in local wafer expansion or even sudden slight movement of the wafer. In turn, this has a detrimental effect on the imaging performance of the lithographic apparatus.

In a particular embodiment (coarse-level correction) of the current invention, this problem is addressed by directing second-type radiation onto the various die areas C around the particular subject die C that is being irradiated with first-type radiation at a given moment. If the source LA is shuttered off (e.g. during motion of the substrate table WT or during alignment and/or levelling operations prior to exposure), then the second-type radiation can, for example:
- also be shuttered off, so that no second-type radiation impinges on the wafer;
- be unpatterned, so that the entire wafer face is irradiated with second-type radiation.
Once the source LA is shuttered open again, and while it remains open, an adjustment is made to the control means to ensure that only the area of the wafer outside the subject die C will receive a flux of second-type radiation. And so forth for each of the subject dies on the substrate W.

The second-type radiation can be conveniently directed onto the wafer W using a secondary source disposed off the optical axis of the projection system PL, or by coupling the second-type radiation into the path of the first-type radiation from the source LA, for example. This latter method may employ a small mirror or prism, disposed near the optical axis of the projection system PL, serving to direct second-type radiation from the (laterally situated) secondary source onto a path along the optical axis and toward the substrate.

### Embodiment 3

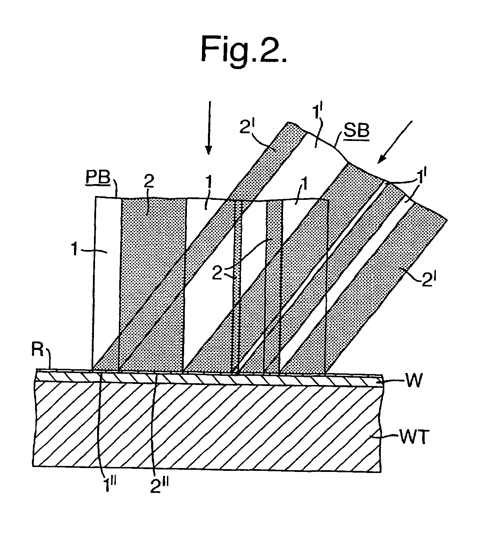

Figure 2 is a magnified cross-section of part of the apparatus of Figure 1, after modification to render it in accordance with a particular embodiment of the present invention. As here depicted, the Figure schematically shows a fine-level correction (see above); however, the basic principle illustrated in the Figure and discussed hereunder apply also to a coarse-level correction.

A wafer W is coated with a resist layer R and is located on top of the wafer table WT. Also depicted is part of the projection beam PB of first-type radiation, which contains "light" regions 1 and "dark" regions 2 in accordance with the pattern on the ask MA (not depicted). The light regions 1 give rise to exposure areas 1" in the resist layer R, whereas the dark regions 2 give rise to non-exposure areas 2" in the layer R; these non-exposure areas 2" are termed as being "in the shadow" with regard to the projection beam PB.

In addition to the chemical exposure effects in the previous paragraph, the projection beam also has a thermal effect on the wafer W, since the layer R and wafer W absorb energy from the beam PB and consequently become heated. As a result, the exposure areas 1" will be heated by the projection beam PB.

The Figure additionally depicts a secondary beam SB of second-type radiation. As in the case of the projection beam PB, the secondary beam SB is patterned, and contains "light" regions 1' and "dark" regions 2'. The patterning of the secondary beam SB is such that the light regions 1' impinge upon the non-exposure areas 2" ("shadow areas") of the resist layer R, whereas the dark regions 2' fall upon the exposure areas 1".

The resist R and the radiation in the secondary beam SB are chosen such that the former is not substantially exposed by the latter; consequently, the secondary beam SB has a negligible effect on the layer R as far as chemical exposure is concerned. However, the radiation in the secondary beam SB is absorbed by the layer R and the wafer W, and causes heating of the wafer W; the non-exposure areas 2" are thus heated by the secondary beam SB. If now the intensity and nature (*e*.*g*. wavelength) of the secondary beam SB are appropriately chosen, then the temperature rise in the non-exposure regions 2" due to beam SB will be substantially equal to the temperature rise in the exposure regions 1" due to beam PB. The net effect is thus a substantially constant heating of the wafer W across its major surface, instead of the differential heating which would occur without the application of the secondary beam SB.

As depicted in Figure 2, the exposure regions 1" and non-exposure regions 2" are located within a given die. However, there will also be non-exposure regions outside that die (*viz*. other dies, and intermediate strips of wafer), and these can, if desired, also be heated by a secondary beam, so as to ensure that they are kept at substantially the same temperature as the die currently being exposed.

In Figure 2, the depicted patterning of the secondary beam SB is such as to have been caused by the use of *e.g*. a stencil plate (not shown). However, the secondary beam SB can also be patterned in another manner, e.g. by scanning a single beam over the resist layer R and modulating its intensity as a function of position: a relatively high intensity is then used in the non-exposure regions 2", and a much lower (or zero) intensity in the exposure regions 1".

As here depicted, the beam SB arrives at the substrate from an off-axis secondary source. In an alternative embodiment, the beam SB can impinge upon the substrate W in a direction substantially perpendicular to the plane of the substrate W; this can be achieved by coupling the beam SB into the beam PB using, for example, a mirror or prism arrangement. The beam SB itself can be derived from a lamp or laser source, and will be focused using a dedicated projection system. The skilled artisan in the field of projection lithography will know how to contrive a suitable secondary source and attendant projection system for use with a chosen second-type radiation.

### Embodiment 4

In the case of an electron-beam or ion-beam lithographic apparatus, the current on/at the reticle is measured. Since the transmitted electrons or ions do not contribute to the measured current, this will be a measure of the pattern density of the reticle; in the case of a SCALPEL reticle, which in principle does not stop any electrons, a measured current difference will be the result of a difference in the generation of secondary electrons in the non-scatter regions and the high-scatter regions. The secondary radiation source can be adjusted as a function of the measured current.

### Embodiment 5

In the case of an electron-beam or ion beam device (once again), the secondary electron signal from the reticle is measured. Electrons or ions that do not pass through an opening in the reticle will generate secondary electrons, which can be detected. Consequently, the measured secondary electron current is a measure of the pattern density on the reticle (this also applies to SCALPEL, on the basis of the same argumentation presented in Embodiment 3). The secondary radiation source can be adjusted as a function of the measured secondary electron current.

### Embodiment 6

In the case of a lithographic projection apparatus employing the SCALPEL principle, there can be a so-called "angle-limiting aperture" located between the reticle and wafer tables. By measuring the current on, or the number of secondary and/or backscattered electrons from, this aperture, one obtains an indicator of the number of scattered electrons: the more electrons scattered, the lower the pattern density on the reticle. Once again, the secondary radiation source can be adjusted as a function of the measured current (direct or secondary / backscattered).

## Claims

1. A lithographic projection apparatus comprising:
. a radiation system (LA, EX, IN, CO) for supplying a projection beam (PB) of radiation of a first type comprising charged particles;
. a mask table (MT) for holding a mask (MA);
. a substrate table (WT) holding a substrate (W) coated with a layer of radiation-sensitive material (R);
. a projection system (PL) for imaging a portion of the mask (MA), irradiated by the projection beam (PB), onto a target portion (C) of the substrate (W);
. a secondary source for supplying radiation of a second type (SB), which can be directed onto the substrate (W) wherein the radiation-sensitive material (R) and the radiations of the first and second types are selected such that the radiation-sensitive material (R) will be exposed by radiation of the first type, and not substantially exposed by radiation of the second type, **characterizing by** further comprising
. control means arranged to pattern the radiation of the second type so that it impinges on the substrate (W) according to a certain pattern,
wherein said pattern of the radiation of the second type is complementary to the distribution of the projection beam (PB) of radiation of the first type directed onto the substrate (W) determined by mask (MA) held by the mask table (MT).

2. Apparatus according to Claim 1, further **characterized in that** the radiation system is embodied to produce a first type of radiation that is selected from the group formed by electrons and ions.

3. Apparatus according to Claim 1 or 2, further **characterized in that** the secondary source is embodied to produce a second type of radiation which is selected from the group formed by microwaves, infrared radiation, visible light, and ultra-violet radiation.

4. Apparatus according to any of the Claims 1-3, further **characterized in that** the control means comprise a stencil plate.

5. Apparatus according to any of the Claims 1-3, further **characterized in that** the control means comprise:
- programmable memory means, for storing information regarding a pattern to be projected from the mask;
- scanning means, for scanning a radiation beam from the secondary light source over the surface of the substrate;
- attenuator means, for adjusting the intensity of the secondary light source during the said scanning motion, on the basis of the information stored in the memory means, thus causing patterned irradiation of the substrate with radiation of the second type.

6. Apparatus according to any of the preceding Claims, further **characterized in that** the control means comprise:
- measurement means, for determining the patterned intensity distribution of radiation of the first type at a reference level between the radiation system and the substrate table;
- patterning means, for patterning the output of the secondary source so as to produce a second-type patterned intensity distribution at substrate level which is substantially a negative of the first-type patterned intensity distribution determined by the measurement means.

7. Apparatus according to Claim 6, further **characterized in that**:
- the measurement means determine the patterned intensity distribution of the charged particles of the radiation of the first type on the basis of a current measurement at the reference level.

8. Apparatus according to Claim 6, further **characterized in that**:
- the measurement means determine the patterned intensity distribution of the charged particles of the radiation of the first type on the basis of a secondary electron signal measurement at the reference level.

9. Apparatus according to any of the Claims 6-8, further **characterized in that** the reference level is at mask level.

10. Apparatus according to any of the Claims 6-8, further **characterized in that** the reference level is at the level of an angle-limiting aperture located in the radiation path between the mask table and the substrate table.

11. Apparatus according to any of the Claims 6-8, further **characterized in that** the reference level is at substrate level.

12. Apparatus according to any one of the preceding claims, wherein the pattern of the radiation of the second type is such that it impinges on substantially the whole substrate area outside the target portion (C) of the substrate (W) irradiated by the projection beam (PB).

13. Apparatus according to any one of the preceding claims, wherein the pattern of the radiation of the second type is such that it impinges on the area of the substrate (2") within the target area (C) which is not irradiated by the radiation of the first type.

14. Apparatus according to any one of the preceding claims arranged such that the radiations of the first and second types can be directed onto the substrate substantially simultaneously.

15. Apparatus according to any one of the preceding claims, wherein said control means is arranged to control the patterning and intensity of the radiation of the second type such that the sum of the fluxes of the radiations of the first and second type at substrate level causes an elevation of the substrate temperature which is substantially constant across at least a given area of the substrate.

16. A device manufacturing method comprising the steps of:
- providing a substrate (W) which is at least partially covered by a layer of radiation-sensitive material (R);
- providing a mask (MA) which contains a pattern;
- using a projection beam (PB) of radiation of a first type comprising charged particles to project an image of at least a part of the mask pattern onto a target area (C) of the layer of radiation-sensitive material, using a projection system (PL), and
using a secondary radiation source and associated control means, to direct radiation of a second type (SB) onto the substrate (W) according to a certain pattern, wherein the radiation-sensitive material (R) and the radiations of the first and second types are selected such that the radiation-sensitive material (R) will be exposed by radiation of the first type, and not substantially exposed by radiation of the second type,
**characterized in that**
said pattern of radiation of the second type is complementary to the distribution of the projection beam (PB) of radiation of the first part directed onto the substrate (W) by the mark (MA) such that the temperature rise in the region illuminated by the radiation of the second type is substantially equal to the temperature rise in the region illuminated by the radiation of the first type.

17. A method according to Claim 16, further **characterized in that** said region illuminated by the radiation of the second type and said region illuminated by the radiation of the first type are substantially the whole major surface of the substrate (W) facing the projection system (PL).

18. A method according to Claim 16, further **characterized in that** said region illuminated by the radiation of the second type and said region illuminated by the radiation of the first type are the said target area (C).

## Patentansprüche

1. Ein lithographischer Projektionsapparat, mit:
einem Bestrahlungssystem (LH, EX, IN, CO) zum Zuführen eines Projektionsstrahls (PB) einer Strahlung eines ersten Typs mit geladenen Partikeln;
einem Maskentisch (MT) zum Halten einer Maske (MA);
einem Substrattisch (WT), der ein Substrat (W) hält, welches mit einer Schicht eines strahlungsempfindlichen Materials (R) überzogen ist;
einem Projektionssystem (PL) zum Abbilden eines Teils der Maske (MA), beleuchtet durch den Projektionsstrahl (PB), auf einen Zielabschnitt (C) des Substrats (W);
einer Sekundärquelle zum Zuführen einer Strahlung eines zweiten Typs (SB), welche auf das Substrat (W) gerichtet werden kann, wobei das strahlungsempfindliche Material (R) und die Strahlungen der ersten und zweiten Typen so gewählt sind, dass das strahlungsempfindliche Material (R) durch Strahlung des ersten Typs belichtet, jedoch durch Strahlung des zweiten Typs im Wesentlichen nicht belichtet wird, weiterhin **gekennzeichnet durch**:
eine Steuervorrichtung, die angeordnet ist, um die Strahlung des zweiten Typs so zu mustern, dass sie auf das Substrat (W) gemäß einem gewissen Muster auftrifft,
wobei das Muster der Strahlung des zweiten Typs komplementär zu der **durch** die Maske (MA), welche **durch** den Maskentisch (MT) gehalten wird, bestimmten Verteilung des Projektionsstrahls (PB) der Strahlung des ersten Typs ist, welche auf das Substrat (W) gerichtet wird.

2. Apparat nach Anspruch 1, weiterhin **dadurch gekennzeichnet, dass** das Bestrahlungssystem so ausgeführt ist, dass es eine Strahlung des ersten Typs erzeugt, ausgewählt aus der Gruppe gebildet durch Elektronen und Ionen.

3. Apparat nach Anspruch 1 oder 2, weiterhin **dadurch gekennzeichnet, dass** die Sekundärquelle so ausgeführt ist, dass sie eine Strahlung eines zweiten Typs erzeugt, ausgewählt aus der Gruppe gebildet durch Mikrowellen, Infrarotstrahlung, sichtbarem Licht und Ultraviolettstrahlung.

4. Apparat nach einem der Ansprüche 1 bis 3, weiterhin **dadurch gekennzeichnet, dass** die Steuervorrichtung eine Schablonenplatte aufweist.

5. Apparat nach einem der Ansprüche 1 bis 3, weiterhin **dadurch gekennzeichnet, dass** die Steuervorrichtung aufweist:
eine programmierbare Speichervorrichtung zur Speicherung von Informationen betreffend ein von der Maske zu projezierendes Muster;
eine Abtastvorrichtung zum Abtasten eines Bestrahlungsstrahls von der sekundären Lichtquelle über die Oberfläche des Substrats hinweg;
eine Dämpfervorrichtung zur Einstellung der Intensität der sekundären Lichtquelle während der Abtastbewegung auf der Grundlage der in der Speichervorrichtung gespeicherten Information, so dass eine gemusterte Beleuchtung des Substrats mit der Strahlung des zweiten Typs bewirkt wird.

6. Apparat nach einem der vorhergehenden Ansprüche, weiterhin **dadurch gekennzeichnet, dass** die Steuervorrichtung aufweist:
eine Messvorrichtung zur Bestimmung der gemusterten Intensitätsverteilung der Strahlung des ersten Typs in einem Referenzniveau zwischen dem Strahlungssystem und dem Substrattisch;
eine Musterungsvorrichtung zur Musterung des Ausgangs der Sekundärquelle derart, dass eine gemusterte Intensitätsverteilung eines zweiten Typs in einem Substratniveau erzeugt wird, welche im Wesentlichen ein Negativwert der gemusterten Intensitätsverteilung des ersten Typs ist, welche durch die Messvorrichtung bestimmt wurde.

7. Apparat nach Anspruch 6, weiterhin **dadurch gekennzeichnet, dass**:
die Messvorrichtung die gemusterte Intensitätsverteilung der geladenen Partikel der Strahlung des ersten Typs auf der Grundlage einer Strommessung bei dem Referenzniveau bestimmt.

8. Apparat nach Anspruch 6, weiterhin **dadurch gekennzeichnet, dass**:
die Messvorrichtung die gemusterte Intensitätsverteilung der geladenen Partikel der Strahlung des ersten Typs auf der Grundlage einer sekundären Elektronensignalmessung bei dem Referenzniveau bestimmt.

9. Apparat nach einem der Ansprüche 6 bis 8, weiterhin **dadurch gekennzeichnet, dass** das Referenzniveau bei dem Maskenniveau ist.

10. Apparat nach einem der Ansprüche 6 bis 8, weiterhin **dadurch gekennzeichnet, dass** das Referenzniveau sich in dem Niveau einer winkelbegrenzenden Apertur befindet, welche in dem Bestrahlungspfad zwischen dem Maskentisch und dem Substrattisch liegt.

11. Apparat nach einem der Ansprüche 6 bis 8, weiterhin **dadurch gekennzeichnet, dass** das Referenzniveau auf Substratniveau liegt.

12. Apparat nach einem der vorhergehenden Ansprüche, wobei das Muster der Strahlung des zweiten Typs derart ist, dass sie im Wesentlichen auf die gesamte Substratfläche außerhalb des Zielabschnitts (C) des Substrats (W) trifft, der von dem Projektionsstrahl (PB) bestrahlt wird.

13. Apparat nach einem der vorhergehenden Ansprüche, wobei das Muster der Strahlung des zweiten Typs derart ist, dass sie auf die Fläche des Substrats (2") innerhalb des Zielbereichs (C) auftrifft, welche nicht durch die Strahlung des ersten Typs bestrahlt wird.

14. Apparat nach einem der vorhergehenden Ansprüche, derart aufgebaut, dass die Strahlungen des ersten und des zweiten Typs im Wesentlichen gleichzeitig auf das Substrat gerichtet werden können.

15. Apparat nach einem der vorhergehenden Ansprüche, wobei die Steuervorrichtung so angeordnet ist, dass sie die Musterung und Intensität der Strahlung des zweiten Typs derart steuert, dass die Summe der Strahlungsflüsse der ersten und zweiten Typen in dem Substratniveau eine Erhöhung der Substrattemperatur bewirken, welche im Wesentlichen konstant zumindest über eine bestimmte Fläche des Substrats hinweg ist.

16. Ein Vorrichtungs-Herstellungsverfahren mit den Schritten von:
Bereitstellen eines Substrats (W), welches zumindest teilweise mit einer Schicht eines strahlungsempfindlichen Materials (R) bedeckt ist;
Bereitstellen einer Maske (MA), welche ein Muster enthält;
Verwenden eines Projektionsstrahls (PB) einer Strahlung eines ersten Typs mit geladenen Partikeln, um ein Bild wenigstens eines Teils des Maskenmusters auf einen Zielbereich (C) der Schicht aus strahlungsempfindlichem Material unter Verwendung eines Projektionssystems (PL) zu projezieren; und
Verwenden einer sekundären Strahlungsquelle und einer zugehörigen Steuervorrichtung, um eine Strahlung eines zweiten Typs (SB) auf das Substrat (W) gemäß einem bestimmten Muster zu richten, wobei das strahlungsempfindliche Material (R) und die Strahlungen der ersten und zweiten Typen so gewählt sind, dass das strahlungsempfindliche Material (R) durch Strahlung des ersten Typs belichtet, jedoch durch Strahlung des zweiten Typs im Wesentlichen nicht belichtet wird,
wobei das Muster der Strahlung des zweiten Typs komplementär zur Verteilung des Projektionsstrahls (PB) der Strahlung des ersten Teils ist, gerichtet auf das Substrat (W) durch die Maske (MA) derart, dass der Temperaturanstieg in dem durch die Strahlung des zweiten Typs beleuchteten Bereichs im Wesentlichen gleich dem Temperaturanstieg in dem Bereich ist, der durch die Strahlung des ersten Typs beleuchtet wird.

17. Ein Verfahren nach Anspruch 16, weiterhin **dadurch gekennzeichnet, dass** der durch die Strahlung des zweiten Typs beleuchtete Bereich und der durch die Strahlung des ersten Typs beleuchtete Bereich im Wesentlichen die gesamte Hauptoberfläche des Substrats (W) sind, welche dem Projektionssystem (PL) entgegen weist.

18. Ein Verfahren nach Anspruch 16, weiterhin **dadurch gekennzeichnet, dass** der durch die Strahlung des zweiten Typs beleuchtete Bereich und der durch die Strahlung des ersten Typs beleuchtete Bereich der Zielbereich (C) sind.

## Revendications

1. Appareil de projection lithographique comportant :
. un système de rayonnement (LA, EX, IN, CO) pour fournir un faisceau de projection (PB) d'un rayonnement d'un premier type comportant des particules chargées;
. une table de masque (MT) pour porter un masque (MA);
. une table de substrat (WT) portant un substrat (W) revêtu d'une couche de matériau sensible au rayonnement (R);
. un système de projection (PL) pour reproduire en image une partie du masque (MA), irradiée par le faisceau de projection (PB), sur une partie cible (C) du substrat (W) ;
. une source secondaire pour fournir un rayonnement d'un second type (SB), qui peut être dirigé sur le substrat (W) dans lequel le matériau sensible au rayonnement (R) et les rayonnements des premier et second types sont sélectionnés de telle sorte que le matériau sensible au rayonnement (R) soit exposé par un rayonnement du premier type, et ne soit pas sensiblement exposé par un rayonnement du second type, **caractérisé en ce qu'**il comporte en outre :
. des moyens de commande agencés pour munir d'un motif le rayonnement du second type de sorte qu'il vienne frapper le substrat (W) selon un certain motif,
dans lequel ledit motif du rayonnement du second type est complémentaire de la distribution du faisceau de projection (PB) du rayonnement du premier type dirigé sur le substrat (W) déterminé par le masque (MA) porté par la table de masque (MT).

2. Appareil selon la revendication 1, **caractérisé de plus en ce que** le système de rayonnement est mis en oeuvre pour produire un premier type de rayonnement qui est sélectionné parmi le groupe formé par des électrons et des ions.

3. Appareil selon la revendication 1 ou 2, **caractérisé de plus en ce que** la source secondaire est mise en oeuvre pour produire un second type de rayonnement qui est sélectionné parmi le groupe formé par des micro-ondes, un rayonnement infrarouge, une lumière visible, et un rayonnement ultraviolet.

4. Appareil selon l'une quelconque des revendications 1 à 3, **caractérisé de plus en ce que** les moyens de commande comportent une plaque de pochoir.

5. Appareil selon l'une quelconque des revendications 1 à 3, **caractérisé de plus en ce que** les moyens de commande comportent :
- des moyens de mémoire programmable, pour mémoriser des informations concernant un motif à projeter à partir du masque,
- des moyens de balayage, pour balayer un faisceau de rayonnement provenant de la source de lumière secondaire sur la surface du substrat,
- des moyens atténuateurs, pour ajuster l'intensité de la source de lumière secondaire pendant ledit mouvement de balayage, sur la base des informations mémorisées dans les moyens de mémoire, provoquant ainsi une irradiation, selon un motif, du substrat avec un rayonnement du second type.

6. Appareil selon l'une quelconque des revendications précédentes, **caractérisé de plus en ce que** les moyens de commande comportent :
- des moyens de mesure, pour déterminer la distribution d'intensité selon un motif du rayonnement du premier type à un niveau de référence entre le système de rayonnement et la table de substrat,
- des moyens de formation de motif, pour munir d'un motif la sortie de la source secondaire de manière à produire une distribution d'intensité selon un motif de second type au niveau du substrat qui est sensiblement un négatif de la distribution d'intensité selon un motif de premier type déterminée par les moyens de mesure.

7. Appareil selon la revendication 6, **caractérisé de plus en ce que** :
- les moyens de mesure déterminent la distribution d'intensité selon un motif des particules chargées du rayonnement du premier type sur la base d'une mesure de courant au niveau de référence.

8. Appareil selon la revendication 6, **caractérisé de plus en ce que** :
- les moyens de mesure déterminent la distribution d'intensité selon un motif des particules chargées du rayonnement du premier type sur la base d'une mesure d'un signal d'électrons secondaire au niveau de référence.

9. Appareil selon l'une quelconque des revendications 6 à 8, **caractérisé de plus en ce que** le niveau de référence est au niveau du masque.

10. Appareil selon l'une quelconque des revendications 6 à 8, **caractérisé de plus en ce que** le niveau de référence est au niveau d'une ouverture de limitation d'angle positionnée dans le trajet du rayonnement entre la table de masque et la table de substrat.

11. Appareil selon l'une quelconque des revendications 6 à 8, **caractérisé de plus en ce que** le niveau de référence est au niveau du substrat.

12. Appareil selon l'une quelconque des revendications précédentes, dans lequel le motif du rayonnement du second type est tel qu'il frappe sensiblement toute la surface du substrat à l'extérieur de la partie cible (C) du substrat (W) irradiée par le faisceau de projection (PB).

13. Appareil selon l'une quelconque des revendications précédentes, dans lequel le motif du rayonnement du second type est tel qu'il frappe la zone du substrat (2") dans la zone cible (C) qui n'est pas irradiée par le rayonnement du premier type.

14. Appareil selon l'une quelconque des revendications précédentes agencé de telle sorte que les rayonnements des premier et second types peuvent être dirigés sur le substrat sensiblement simultanément.

15. Appareil selon l'une quelconque des revendications précédentes, dans lequel lesdits moyens de commande sont agencés pour commander le motif et l'intensité du rayonnement du second type de telle sorte que la somme des flux des rayonnements du premier et du second type au niveau du substrat provoque une élévation de la température de substrat qui est sensiblement constante à travers au moins une zone donnée du substrat.

16. Procédé de fabrication de dispositif comportant les étapes consistant à :
- fournir un substrat (W) qui est au moins partiellement recouvert d'une couche de matériau sensible au rayonnement (R);
- fournir un masque (MA) qui contient un motif;
- utiliser un faisceau de projection (PB) de rayonnement d'un premier type comportant des particules chargées pour projeter une image d'au moins une partie du motif du masque sur une zone cible (C) de la couche de matériau sensible au rayonnement, en utilisant un système de projection (PL), et
utiliser une source de rayonnement secondaire et des moyens de commande associés, pour diriger un rayonnement d'un second type (SB) sur le substrat (W) conformément à un certain motif, dans lequel le matériau sensible au rayonnement (R) et les rayonnements des premier et second types sont sélectionnés de telle sorte que le matériau sensible au rayonnement (R) soit exposé à un rayonnement du premier type, et ne soit pas sensiblement exposé à un rayonnement du second type,
**caractérisé en ce que** ledit motif de rayonnement du second type est complémentaire de la distribution du faisceau de projection (PB) du rayonnement de la première partie dirigée sur le substrat (W) par le masque (MA) de telle sorte que la montée en température dans la zone éclairée par le rayonnement du second type est sensiblement égale à la montée en température dans la zone éclairée par le rayonnement du premier type.

17. Procédé selon la revendication 16, **caractérisé de plus en ce que** ladite zone éclairée par le rayonnement du second type et ladite zone éclairée par le rayonnement du premier type constituent sensiblement toute la surface principale du substrat (W) situé en vis-à-vis du système de projection (PL).

18. Procédé selon la revendication 16, **caractérisé de plus en ce que** ladite zone éclairée par le rayonnement du second type et ladite zone éclairée par le rayonnement du premier type sont ladite zone cible (C).
